# EUROPEAN PATENT APPLICATION

(11) **EP 4 686 977 A1**
(43) Date of publication of application: **04.02.2026**
(21) Application number: 25188623.0
(22) Date of filing: 09.07.2025
(51) Int. Cl.: G02B 27/01, G09F 9/33

(54) **DISPLAY DEVICE**

(30) Priority: 01.08.2024 CN 202411045121
(71) Applicant: InnoLux Corporation, Jhu-Nan, Miao-Li County 350 (TW)
(72) Inventor: KUO, Shu-Ming, 350 Miao-Li County (TW); HSIEH, Tsau-Hua, 350 Miao-Li County (TW); SHIH, Jian-Jung, 350 Miao-Li County (TW)
(74) Representative: Straus, Alexander

(57) **Abstract**

A display device (DE) for projecting light (L) to an object (OB) includes a substrate (100) having a first region (I) and a second region (II) respectively overlapping a first curved surface (S1) and a second curved surface (S2) of the object (OB); light-emitting elements (200) disposed on the substrate (100); and a light adjusting layer (300) disposed on the light-emitting elements (200) and including a first light-adjusting element (310) enabling a first light-emitting element (210) disposed in the first region (I) to emit light with a first light-emitting direction (L1) and a second light-adjusting element (320) enabling a second light-emitting element (220) disposed in the second region (II) to emit light with a second light-emitting direction (L2). An included angle (β2) between the second light-emitting direction (L2) and a normal direction (D2) is greater than that between the first light-emitting direction (L1) and the normal direction (D2).

## Description

### Field of the Disclosure

The present disclosure relates to a display device, and more particularly to a display device used for projecting light to an object.

### Background of the Disclosure

In recent years, display devices have become more and more important in various electronic applications. In prior art, display devices may further have the function of projecting images. For example, the display device may be applied to a vehicle display capable of projecting an image to a windshield. However, since the surface of the windshield is curved, light emitted by the display device from different positions may have different incident angles on the windshield, resulting in image distortion or uneven brightness.

### Summary of the Disclosure

The present disclosure aims at providing a display device, wherein a light adjusting layer including a plurality of light-adjusting elements is disposed on light-emitting elements, so that the light may be emitted with different emitting angles in different regions, thereby alleviating the problem of image distortion or uneven brightness.

This is achieved by a display device according to the claims. The dependent claims pertain to corresponding further developments and improvements.

As will be seen more clearly from the detailed description following below, a display device, which is used for projecting light to an object having a first curved surface and a second curved surface, is provided by the present disclosure. The display device includes a substrate, a plurality of light-emitting elements and a light adjusting layer. The substrate has a first region overlapping the first curved surface and a second region overlapping the second curved surface, and an included angle between a normal direction of the substrate and a normal direction of the second curved surface is greater than an included angle between the normal direction of the substrate and a normal direction of the first curved surface. The plurality of light-emitting elements are disposed on the substrate and include a first light-emitting element and a second light-emitting element. The first light-emitting element is disposed in the first region, and the second light-emitting element is disposed in the second region. The light adjusting layer is disposed on the plurality of light-emitting elements and includes a first light-adjusting element and a second light-adjusting element. The first light-adjusting element is used for enabling the first light-emitting element to emit a first emitted light with a first light-emitting direction, and the second light-adjusting element is used for enabling the second light-emitting element to emit a second emitted light with a second light-emitting direction. An included angle between the second light-emitting direction and the normal direction of the substrate is greater than an included angle between the first light-emitting direction and the normal direction of the substrate.

These and other objectives of the present disclosure will no doubt become obvious to those of ordinary skill in the art after reading the following detailed description of the embodiment that is illustrated in the various figures and drawings.

### Brief Description of the Drawings

**In** the following, the disclosure is further illustrated by way of example, taking reference to the accompanying drawings. Thereof:
FIG. 1 is a side-view schematic diagram of a display device projecting light to an object according to an embodiment of the present disclosure;
FIG. 2 is a top-view schematic diagram of an object according to an embodiment of the present disclosure;
FIG. 3 is a height-variation schematic diagram of the object shown in FIG. 2;
FIG. 4 is a side-view schematic diagram of an embodiment of a display device projecting light to an object according to the present disclosure;
FIG. 5 is a partial cross-sectional schematic diagram of a display device according to a first embodiment of the present disclosure;
FIG. 6 is a partial cross-sectional schematic diagram of a display device according to a variation embodiment of a first embodiment of the present disclosure;
FIG. 7 is a partial cross-sectional schematic diagram of a display device according to a second embodiment of the present disclosure;
FIG. 8 is a partial cross-sectional schematic diagram of a display device according to a third embodiment of the present disclosure; and
FIG. 9 is a partial cross-sectional schematic diagram of a display device according to a fourth embodiment of the present disclosure.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of the device or structure, and certain components in various drawings may not be drawn to scale. In addition, the number and dimension of each component shown in drawings are only illustrative and are not intended to limit the scope of the present disclosure.

Certain terms are used throughout the description and following claims to refer to particular components. As one skilled in the art will understand, electronic equipment manufacturers may refer to a component by different names. This document does not intend to distinguish between components that differ in name but not function. In the following description and in the claims, the terms "include", "comprise" and "have" are used in an open-ended fashion, and thus should be interpreted to mean "include, but not limited to...". When the terms "include", "comprise" and/or "have" are used in the description of the present disclosure, the corresponding features, areas, steps, operations and/or components would be pointed to existence, but not limited to the existence or addition of one or a plurality of the corresponding or other features, areas, steps, operations, components and/or combinations thereof.

When an element or layer is referred to as being "on" or "connected to" another element or layer, it may be directly on or directly connected to the other element or layer, or intervening elements or layers may be presented (indirect condition). In contrast, when an element is referred to as being "directly on" or "directly connected to" another element or layer, there are no intervening elements or layers presented.

The directional terms mentioned in this document, such as "up", "down", "front", "back", "left", "right", etc., are only directions referring to the drawings. Therefore, the directional terms used are for illustration, not for limitation of the present disclosure.

The terms "about", "equal", "identical" or "the same", and "substantially" or "approximately" mentioned in this document generally mean being within 20% of a given value or range, or being within 10%, 5%, 3%, 2%, 1% or 0.5% of a given value or range.

The ordinal numbers used in the description and claims, such as "first", "second", "third", etc., are used to describe elements, but they do not mean and represent that the element(s) have any previous ordinal numbers, nor do they represent the order of one element and another element, or the order of manufacturing methods. The ordinal numbers are used only to clearly discriminate an element with a certain name from another element with the same name. The claims and the description may not use the same terms. Accordingly, in the following description, a first constituent element may be a second constituent element in a claim.

The display device of the present disclosure may be applied in an electronic device, wherein the display device may include a non-self-emissive display device or a self-emissive display device. In addition, the electronic device may further include a backlight device, an antenna device, a sensing device or a tiled device, but not limited herein. The electronic device may include a bendable or flexible electronic device. The antenna device may include a liquid-crystal type antenna device or an antenna device other than liquid-crystal type, and the sensing device may include a sensing device used for sensing capacitance, light, heat or ultrasonic waves, but not limited herein. The electronic device may include electronic elements such as passive elements and active elements, for example, capacitors, resistors, inductors, diodes, transistors, etc. The diode may include a light-emitting diode or a photodiode. For example, the light-emitting diode may include an organic light-emitting diode (OLED), a mini light-emitting diode (mini LED), a micro light-emitting diode (micro LED) or a quantum dot light-emitting diode (quantum dot LED), but not limited herein. The tiled device may be, for example, a display tiled device or an antenna tiled device, but not limited herein. It should be noted that the electronic device may be any arrangement and combination of the above, but not limited herein.

It should be noted that the technical features in different embodiments described in the following can be replaced, recombined, or mixed with one another to constitute another embodiment without departing from the spirit of the present disclosure.

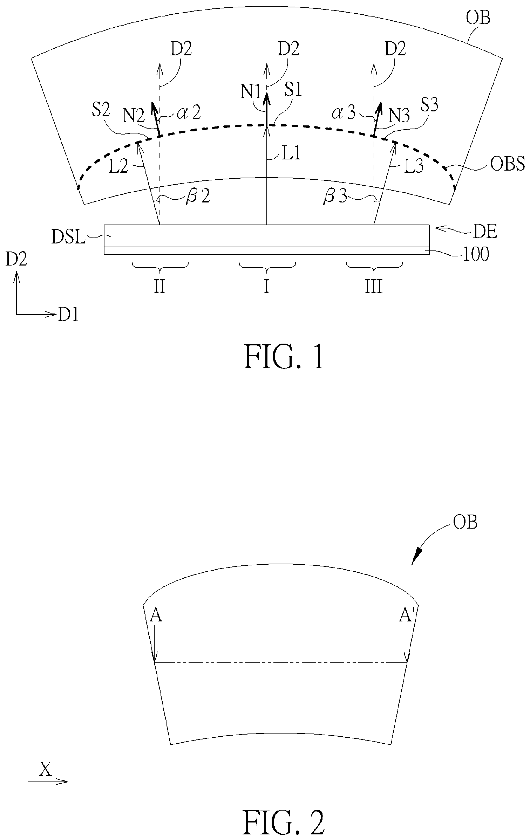

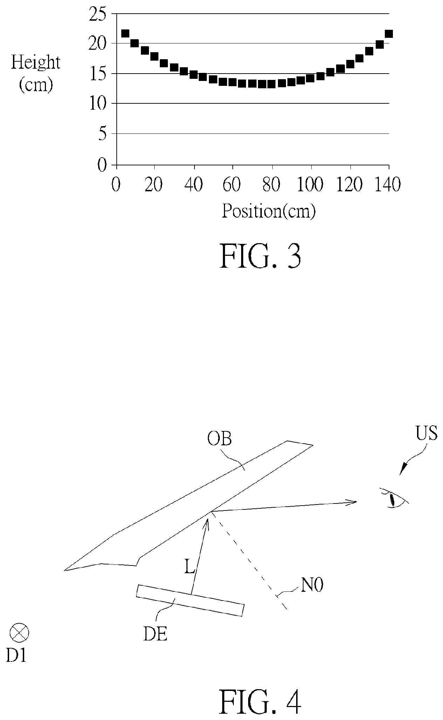

Please refer to FIG. 1, FIG. 2 and FIG. 3. FIG. 1 is a side-view schematic diagram of a display device projecting light to an object according to an embodiment of the present disclosure. FIG. 2 is a top-view schematic diagram of an object according to an embodiment of the present disclosure. FIG. 3 is a height-variation schematic diagram of the object shown in FIG. 2, wherein FIG. 3 shows the height change of an object OB at different positions along a direction X corresponding to the section line A-A' of FIG. 2. As shown in FIG. 1, FIG. 2 and FIG. 3, a display device DE is used for projecting light to the object OB. For example, the light emitted by the display device DE may be projected onto the object OB to form one or a plurality of projected images. The vertical axis in FIG. 3 represents the height, and the horizontal axis represents the different positions of the object OB along the direction X, wherein the direction X may be parallel to the horizontal direction, and each of the points shown in FIG. 3 may represent the distance between the reference horizontal plane and the surface (e.g., the upper surface) of the object OB at different positions while the object OB is laid on the horizontal plane. It should be known from the curve shown in FIG. 3 that the height of the object OB may change from high to low and then from low to high in the direction X as a curve variation, that is, the object OB may have a curved surface OBS, as shown in FIG. 1. In some embodiments, the object OB may be, for example (but not limited to), a windshield with the curved surface OBS protruding toward the outside of a vehicle. According to the embodiment shown in FIG. 1, the curved surface OBS of the object OB has a first curved surface S1 and a second curved surface S2, wherein the first curved surface S1 and the second curved surface S2 are different parts of the curved surface OBS. It should be noted that although the curved surface OBS is a surface and the first curved surface S1 and the second curved surface S2 are parts of the curved surface OBS respectively, in order to facilitate the expression and explanation of the spirit of the present disclosure, the curved surface OBS is represented by a curved line in FIG. 1, and the first curved surface S1 and the second curved surface S2 are represented by a line segment region of the curved line respectively. In some embodiments, the curved surface OBS of the object OB may further have a third curved surface S3, and the first curved surface S1 may be located between the second curved surface S2 and the third curved surface S3 in a first direction D1, wherein the first direction D1 may be parallel to the horizontal direction. For example, the first direction D1 may be a direction viewed from a window adjacent to a driver's seat toward another window adjacent to a passenger's seat. As an example, please refer to FIG. 3, which is a side-view schematic diagram of an embodiment of a display device projecting light to an object according to the present disclosure, wherein FIG. 3 is a side view in a perspective along the first direction D1. As shown in FIG. 3, the object OB may be a windshield of a vehicle for example, and the display device DE is used for being installed in the vehicle and projecting light L to the object OB. A user US at a side of the object OB may view the image formed by the light L projected to the object OB, wherein the angle between the light L projected to the object OB and a normal direction N0 of the curved surface OBS of the object OB may be 30 degrees to 70 degrees.

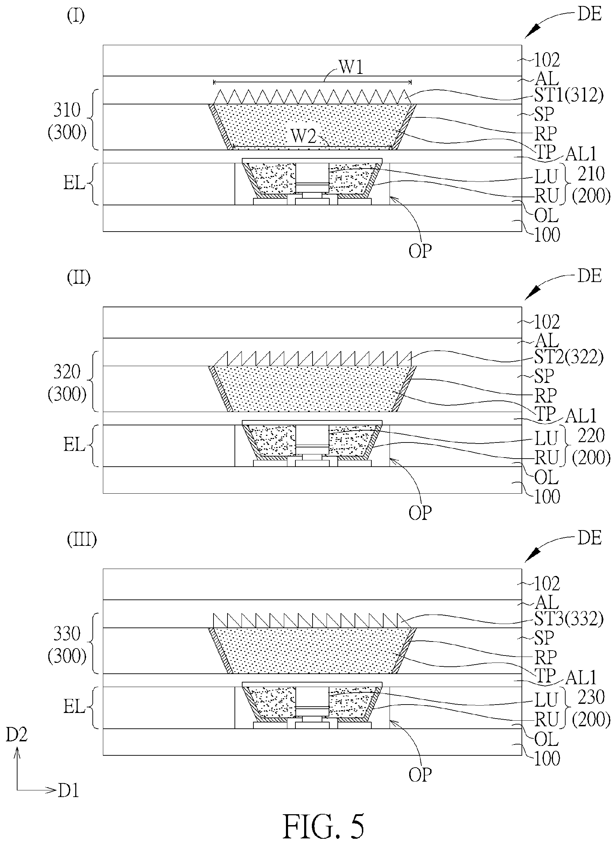

Please refer to FIG. 5, in conjunction with FIG. 1. FIG. 5 is a partial cross-sectional schematic diagram of a display device according to a first embodiment of the present disclosure, wherein the cross-sectional structures at the upper portion, the middle portion and the lower portion of FIG. 5 may correspond to the first region I, the second region II and the third region III shown in FIG. 1, respectively. As shown in FIG. 1 and FIG. 5, the display device DE includes a substrate 100, a plurality of light-emitting elements 200 and a light adjusting layer 300, wherein the light-emitting elements 200 and the light adjusting layer 300 may correspond to a display layer DSL shown in FIG. 1. The substrate 100 has a first region I and a second region II. In a second direction D2, the first region I overlaps the first curved surface S1, and the second region II overlaps the second curved surface S2. The second direction D2 is a normal direction of the substrate 100, and the second direction D2 is different from the first direction D1. For example, the second direction D2 may be perpendicular to the first direction D1. The substrate 100 of this embodiment is a flat plate and does not have a curved surface, but not limited herein. Furthermore, an included angle α2 between the second direction D2 (i.e., the normal direction of the substrate 100) and a normal direction N2 of the second curved surface S2 is greater than an included angle α1 between the second direction D2 and a normal direction N1 of the first curved surface S1. According to the embodiment shown in FIG. 1, the included angle α1 may be 0 for example and not labeled in FIG. 1, but the present disclosure is not limited herein, while the included angle α1 may be different from 0 and less than the included angle α2 in other embodiments. In some embodiments, the substrate 100 may further have a third region III, the first region I may be located between the second region II and the third region III in the first direction D1, and the third region III overlaps the third curved surface S3. An included angle α3 between the second direction D2 (i.e., the normal direction of the substrate 100) and a normal direction N3 of the third curved surface S3 may be greater than the included angle α1 between the second direction D2 and the normal direction N1 of the first curved surface S1, wherein the included angle α3 may be equal to or different from the included angle α2. The substrate 100 may be a hard substrate or a flexible substrate. The hard substrate may include, for example, glass, ceramics or sapphire, and the flexible substrate may include, for example, polyimide (PI), polycarbonate (PC), polyethylene terephthalate (PET), poly(methyl methacrylate) (PMMA) or a composite layer composed of organic material and inorganic material, but not limited herein.

The plurality of light-emitting elements 200 are disposed on the substrate 100, which may serve as a light source. The plurality of light-emitting elements 200 include a first light-emitting element 210 and a second light-emitting element 220, the first light-emitting element 210 is disposed in the first region I, and the second light-emitting element 220 is disposed in the second region II. In some embodiments, the plurality of light-emitting elements 200 may further include a third light-emitting element 230 disposed in the third region III. According to the embodiment shown in FIG. 5, the display device DE may include, for example, a light-emitting layer EL disposed on the substrate 100, and the light-emitting layer EL may include an organic layer OL and the plurality of light-emitting elements 200. The organic layer OL includes a plurality of openings OP, and each of the light-emitting elements 200 may be correspondingly disposed in one of the openings OP. The organic layer OL may include, for example (but not limited to), an organic photoresist material, and the color thereof may be transparent, black or white. In some embodiments, one light-emitting element 200 (e.g., the first light-emitting element 210, the second light-emitting element 220 or the third light-emitting element 230) may include a light-emitting unit LU and a reflective unit RU, the reflective unit RU may be disposed around the light-emitting unit LU, and the light-emitting unit LU and the reflective unit RU may be disposed in one of the openings OP. The reflective unit RU is used for reflecting the light emitted by the light-emitting unit LU, so that the light is concentrated and emitted substantially toward one direction (e.g., upward), thereby improving the luminous efficiency of the light-emitting element 200. The light-emitting unit LU may be, for example, an organic light-emitting diode (OLED), a light-emitting diode (LED) or a quantum dot LED (QLED), but not limited herein.

The light adjusting layer 300 is disposed on the plurality of light-emitting elements 200. The light adjusting layer 300 includes a first light-adjusting element 310 and a second light-adjusting element 320, the first light-adjusting element 310 may be disposed corresponding to the first light-emitting element 210 and used for enabling the first light-emitting element 210 to emit a first emitted light with a first light-emitting direction L1, and the second light-adjusting element 320 may be disposed corresponding to the second light-emitting element 220 and used for enabling the second light-emitting element 220 to emit a second emitted light with a second light-emitting direction L2. An included angle β2 between the second light-emitting direction L2 and the second direction D2 (i.e., the normal direction of the substrate 100) is greater than an included angle β1 between the first light-emitting direction L1 and the second direction D2. According to the embodiment shown in FIG. 1, the included angle β1 may be 0 for example and not labeled in FIG. 1, but the present disclosure is not limited herein, while the included angle β1 may be different from 0 and less than the included angle β2 in other embodiments. In some embodiments, the light adjusting layer 300 may further include a third light-adjusting element 330, and the third light-adjusting element 330 may be disposed corresponding to the third light-emitting element 230 and used for enabling the third light-emitting element 230 to emit a third emitted light with a third light-emitting direction L3. An included angle β3 between the third light-emitting direction L3 and the second direction D2 (i.e., the normal direction of the substrate 100) is greater than the included angle β1 between the first light-emitting direction L1 and the second direction D2, wherein the included angle β3 may be equal to or different from the included angle β2.

FIG. 5 shows the partial cross-sectional structures corresponding to the first region I, the second region II and the third region III of the substrate 100 shown in FIG. 1, but the substrate 100 may be divided into a plurality of regions in practice, and according to the bending degree of the curved surface OBS of the object OB, the light-adjusting elements in the light adjusting layer 300 may correspondingly adjust the included angle between the light-emitting direction of the emitted light in each region and the second direction D2 (i.e., the normal direction of the substrate 100), so that the degrees of the included angles gradually change corresponding to different regions. According to the above structural design, the plurality of light-adjusting elements (such as the first light-adjusting element 310, the second light-adjusting element 320 and/or the third light-adjusting element 330) of the light adjusting layer 300 enable the emitted light of the light-emitting elements 200 in different regions has different emitting angles, so that the distortion of the projected image projected by the light onto the object OB may be reduced, and the uniformity of brightness of the emitted light may be improved, thereby improving the image quality.

According to the embodiment shown in FIG. 5, the first light-adjusting element 310 may include a first prism portion 312, the second light-adjusting element 320 may include a second prism portion 322, and in a cross-sectional view of the display device DE, the first prism portion 312 includes a plurality of symmetric structures ST1, and the second prism portion 322 includes a plurality of asymmetric structures ST2. The first emitted light of the first light-emitting element 210 may pass through the first prism portion 312 and have the first light-emitting direction L1 (shown in FIG. 1), the second emitted light of the second light-emitting element 220 may be deflected (e.g., deflected to the left) by the second prism portion 322 and have the second light-emitting direction L2 (shown in FIG. 1). For example, the symmetric structures ST1 of the first prism portion 312 may be equilateral triangles, and the asymmetric structures ST2 of the second prism portion 322 may be non-equilateral triangles (e.g., a right triangle with an inclined plane on the left), but not limited herein. In some embodiments, the third light-adjusting element 330 may include a third prism portion 332, and in the cross-sectional view of the display device DE, the third prism portion 332 includes a plurality of asymmetric structures ST3. The third emitted light of the third light-emitting element 230 may be deflected (e.g., deflected to the right) by the third prism portion 332 and have the third light-emitting direction L3 (shown in FIG. 1). For example, the asymmetric structures ST3 of the third prism portion 332 may be non-equilateral triangles (e.g., a right triangle with an inclined plane on the right), but not limited herein. According to the above structural design, the plurality of light-adjusting elements (such as the first light-adjusting element 310, the second light-adjusting element 320 and/or the third light-adjusting element 330) of the light adjusting layer 300 have different types of prism portions, which may enable the emitted light of the light-emitting elements 200 in different regions has different emitting angles, so that the uniformity of the light brightness may be improved and the distortion of the projected image may be reduced.

As shown in FIG. 5, the first light-adjusting element 310 may further include a light-transmitting portion TP and a reflective portion RP, the reflective portion RP is disposed around the light-transmitting portion TP, and the first prism portion 312 is disposed on the light-transmitting portion TP. The first emitted light of the first light-emitting element 210 may pass through the light-transmitting portion TP and may be reflected by the reflective portion RP, so that the light is concentrated and emitted substantially toward one direction (e.g., upward), thereby improving the luminous efficiency. The light-transmitting portion TP may include light-transmitting material, such as (but not limited to) acrylic material, epoxy material, siloxane, silica or other suitable materials. The reflective portion RP may include metal material or a distributed Bragg reflector (DBR), wherein the metal material includes, for example (but not limited to), silver (Ag), aluminum (Al) or other suitable materials. The first light-adjusting element 310 may further include a supporting portion SP surrounding the reflective portion RP. The supporting portion SP may include, for example (but not limited to), organic photoresist material. In the cross-sectional view as shown in FIG. 5, a top surface width W1 of the light-transmitting portion TP is greater than a bottom surface width W2 of the light-transmitting portion TP, so that the emitting angle of the emitted light may be wider. In some embodiments, the width of the light-transmitting portion TP may be gradually reduced from the top to bottom, that is, the width between the top surface width W1 and the bottom surface width W2 is gradually reduced, but not limited herein. According to the embodiment shown in FIG. 5, the second light-adjusting element 320 and/or the third light-adjusting element 330 may also include the above-mentioned light-transmitting portion TP, reflective portion RP and supporting portion SP, and the second prism portion 322/the third prism portion 332 is disposed on the light-transmitting portion TP to improve the luminous efficiency.

In some embodiments, as shown in FIG. 5, the display device DE may further optionally include another substrate 102 and an adhesive layer AL, and the adhesive layer AL is disposed on the surface of the substrate 102. The adhesive layer AL may cover the first prism portion 312 of the first light-adjusting element 310, the second prism portion 322 of the second light-adjusting element 320 and the third prism portion 332 of the third light-adjusting element 330, i.e., the adhesive layer AL may be located between the light adjusting layer 300 and the substrate 102 in the second direction D2. In some embodiments, the refractive index of the adhesive layer AL is less than the refractive indexes of the first prism portion 312, the second prism portion 322 and the third prism portion 332. The display device DE may further optionally include an adhesive layer AL1, and the light adjusting layer 300 located at one side of the substrate 102 may be attached to the light-emitting layer EL through the adhesive layer AL1, i.e., the adhesive layer AL1 may be located between the light adjusting layer 300 and the light-emitting layer EL in the second direction D2. The adhesive layer AL and the adhesive layer AL1 may include optical adhesive, such as (but not limited to) optical clear adhesive (OCA) or optical clear resin (OCR).

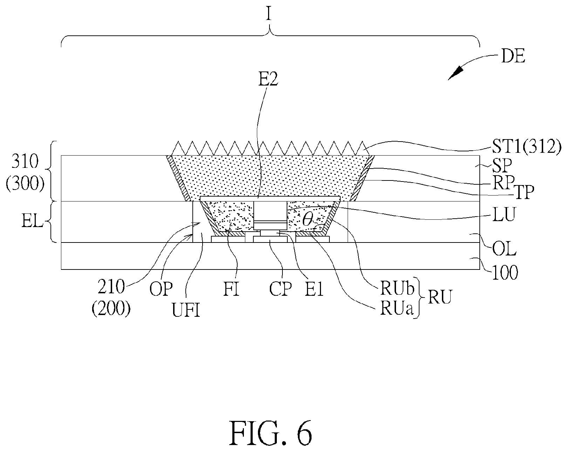

Please refer to FIG. 6, which is a partial cross-sectional schematic diagram of a display device according to a variation embodiment of a first embodiment of the present disclosure, wherein the cross-sectional structure shown in FIG. 6 may correspond to the first region I shown in FIG. 1. The display device DE shown in FIG. 6 is different from the first embodiment shown in FIG. 5 in that the display device DE includes only one substrate 100. That is to say, as shown in FIG. 6, the light-emitting layer EL and the light adjusting layer 300 may be stacked and disposed on the substrate 100 in sequence along the second direction D2, wherein the display device DE does not include another substrate 102, the adhesive layer AL and the adhesive layer AL1 shown in FIG. 5.

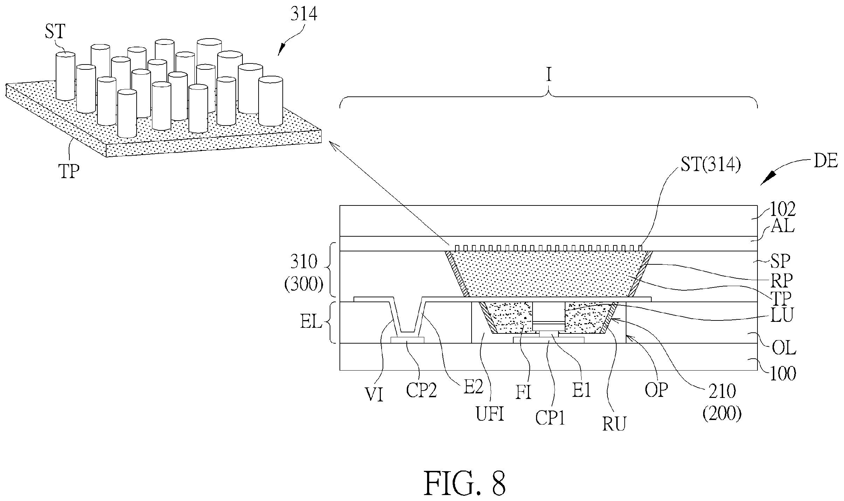

The light-emitting elements 200 (e.g., the first light-emitting element 210 shown in FIG. 6, the first light-emitting element 210, the second light-emitting element 220 and the third light-emitting element 230 shown in FIG. 5, and the first light-emitting element 210 shown in FIG. 8) may include vertical-type light-emitting elements, but not limited herein. The detailed structure of the light-emitting element 200 according to an embodiment of the present disclosure will be further described in the following. Specifically, as shown in FIG. 6, one light-emitting element 200 may include a light-emitting unit LU, a first electrode E1, a second electrode E2, a reflective unit RU, a filling material FI and a plurality of connection pads CP. For example, one side of the light-emitting unit LU may be doped as a p-type semiconductor, the other side thereof may be doped as an n-type semiconductor, and a p-n junction exists between the p-type semiconductor and the n-type semiconductor in the second direction D2, but not limited herein. The first electrode E1 and the second electrode E2 may be respectively disposed at two sides of the light-emitting unit LU and may be opposite to each other in the second direction D2. The plurality of connection pads CP may be disposed on the substrate 100, and the plurality of connection pads CP may be disposed in the opening OP of the organic layer OL. The first electrode E1 may be disposed on one of the connection pads CP, and the light-emitting unit LU may be electrically connected to the one of the connection pads CP through the first electrode E1. In some embodiments, the reflective unit RU and the first electrode E1 may include the same material. The reflective unit RU may be disposed around the light-emitting unit LU and connected to another one or more of the connection pads CP, wherein the reflective unit RU has a bottom part RUa and a side wall RUb, the bottom part RUa is disposed on the another one or other ones of the connection pads CP, and an included angle θ exists between the side wall RUb and the bottom part RUa. The included angle θ may ranges from, for example (but not limited to), 100 degrees to 170 degrees or 120 degrees to 160 degrees. The opposite two ends of the second electrode E2 in the first direction D1 may be connected to the side wall RUb of the reflective unit RU, and the light-emitting unit LU may be electrically connected to the another one or other ones of the connection pads CP through the second electrode E2 and the reflective unit RU. The filling material FI may be filled between the reflective unit RU and the second electrode E2, and the filling material FI may surround the light-emitting unit LU. According to the structural design of the light-emitting element 200, the luminous efficiency thereof may be improved. In some embodiments, an underfill material UFI may further be filled in the opening OP of the organic layer OL, i.e., the underfill material UFI may be disposed between the light-emitting element 200 and the side wall of the opening OP, but not limited herein. A reflective layer (not shown) may be optionally disposed between the light-emitting unit LU and the first electrode E1, so as to further improve the luminous efficiency.

In some embodiments, the filling material FI may include a light-transmitting material with a transmittance of more than 90% for visible light, such as (but not limited to) acrylic material, epoxy material, siloxane, silica or other suitable materials. The first electrode E1 and the second electrode E2 may include transparent conductive oxide material or metal material, such as (but not limited to) indium tin oxide (ITO). The connection pad CP may include metal material, such as (but not limited to) gold (Au), tin (Sn), copper (Cu), indium (In), other suitable materials or a composite material of a combination of the above materials. The reflective unit RU may include metal material, a distributed Bragg reflector or a combination of the above materials, wherein the metal material includes, for example (but not limited to), silver, aluminum or other suitable materials. For example, the reflective unit RU may be formed by stacking pure metal or alloy, which has relatively high reflectivity and provides reflection and electrical connection functions at the same time, or the reflective unit RU may be formed by wrapping a metal conductive layer on the outside of the distributed Bragg reflector, or the reflective unit RU may be formed by a high reflective metal and stacking another metal for bonding on the bonding side thereof, but the present disclosure is not limited to the above. The reflective unit RU and the connection pad CP may include the same or different materials. The underfill material UFI may include acrylic material, epoxy material, siloxane, silica or other suitable materials.

The display device of the present disclosure is not limited to the above embodiments. Some embodiments of the display devices of the present disclosure will be detailed in the following. In order to simplify the illustration, the same elements in the following would be labeled with the same symbols. The differences between different embodiments are described in detail below, and the same features would not be described redundantly.

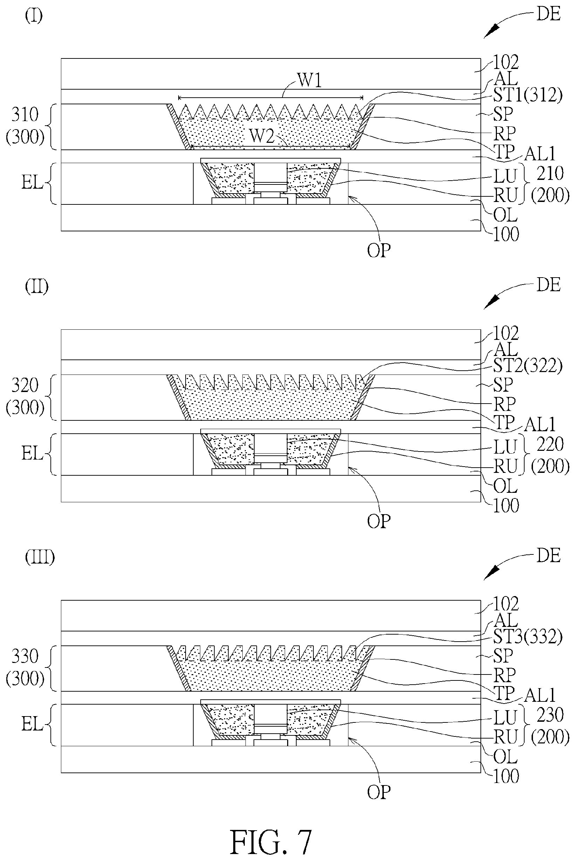

Please refer to FIG. 7, in conjunction with FIG. 1. FIG. 7 is a partial cross-sectional schematic diagram of a display device according to a second embodiment of the present disclosure, wherein the cross-sectional structures at the upper portion, the middle portion and the lower portion of FIG. 7 may correspond to the first region I, the second region II and the third region III shown in FIG. 1, respectively. The display device DE shown in FIG. 7 is different from the first embodiment shown in FIG. 5 in that the first prism portion 312 of the first light-adjusting element 310 may be embedded in the light-transmitting portion TP, the second prism portion 322 of the second light-adjusting element 320 may be embedded in the light-transmitting portion TP, and the third prism portion 332 of the third light-adjusting element 330 may be embedded in the light-transmitting portion TP. Specifically, as shown in FIG. 7, the first light-adjusting element 310 includes the first prism portion 312, the light-transmitting portion TP and the reflective portion RP, the reflective portion RP is disposed around the light-transmitting portion TP, and a plurality of recesses may be formed at the surface of the light-transmitting portion TP, so that the plurality of symmetric structures ST1 of the first prism portion 312 are embedded in the light-transmitting portion TP. The first emitted light of the first light-emitting element 210 may pass through the first prism portion 312 and have the first light-emitting direction L1 (shown in FIG. 1).

Similarly, in the second embodiment, a plurality of recesses may be formed at the surface of the light-transmitting portion TP of the second light-adjusting element 320, so that the plurality of asymmetric structures ST2 of the second prism portion 322 are embedded in the light-transmitting portion TP. The second emitted light of the second light-emitting element 220 may be deflected (e.g., deflected to the left) by the second prism portion 322 and have the second light-emitting direction L2 (shown in FIG. 1). A plurality of recesses may be formed at the surface of the light-transmitting portion TP of the third light-adjusting element 330, so that the plurality of asymmetric structures ST3 of the third prism portion 332 are embedded in the light-transmitting portion TP. The third emitted light of the third light-emitting element 230 may be deflected (e.g., deflected to the right) by the third prism portion 332 and have the third light-emitting direction L3 (shown in FIG. 1). According to the above structural design, the plurality of light-adjusting elements (such as the first light-adjusting element 310, the second light-adjusting element 320 and/or the third light-adjusting element 330) of the light adjusting layer 300 have different types of prism portions, which may enable the emitted light of the light-emitting elements 200 in different regions has different emitting angles, so that the uniformity of the projected image and light brightness are improved.

In the cross-sectional view as shown in FIG. 7, the top surface width W1 of the light-transmitting portion TP may be greater than the bottom surface width W2 of the light-transmitting portion TP, so that the emitting angle of the emitted light may be wider. In some embodiments, the width of the light-transmitting portion TP may be gradually reduced from the top to bottom, that is, the width between the top surface width W1 and the bottom surface width W2 is gradually reduced, but not limited herein. In some embodiments, as shown in FIG. 7, the adhesive layer AL may be located between the light adjusting layer 300 and the substrate 102, and the adhesive layer AL may be filled in the recesses at the surfaces of the first light-adjusting element 310, the second light-adjusting element 320 and the third light-adjusting element 330. In some embodiments, the refractive index of the adhesive layer AL is less than the refractive indexes of the first prism portion 312, the second prism portion 322 and the third prism portion 332.

Please refer to FIG. 8, which is a partial cross-sectional schematic diagram of a display device according to a third embodiment of the present disclosure, wherein the cross-sectional structure shown at the right portion of FIG. 8 may correspond to the first region I shown in FIG. 1. The display device DE shown in FIG. 8 is different from the first embodiment shown in FIG. 5 in that each of the light-adjusting elements (such as the first light-adjusting element 310, the second light-adjusting element 320 and the third light-adjusting element 330) of the light adjusting layer 300 may include a metalens. Specifically, as shown in FIG. 8, the first light-adjusting element 310 may include a first metalens 314, and the first metalens 314 may be, for example, disposed on the light-transmitting portion TP. The first metalens 314 may include a plurality of microstructures ST, and the plurality of microstructures ST are disposed on the light-transmitting portion TP. The left portion of FIG. 8 shows a partially enlarged stereo structure schematic diagram of the first metalens 314, wherein the plurality of microstructures ST may be micro/nanostructure and distributed in an array arrangement, and each of the microstructures ST may be column-shaped (e.g., a cylinder). In some embodiments, the diameter of the microstructure ST may be less than 300 nanometers, and/or the spacing between two adjacent microstructures ST may be less than 300 nanometers, but not limited herein. The microstructure ST may, for example (but not limited to), include metal material. The first emitted light of the first light-emitting element 210 may pass through the first metalens 314 and have the first light-emitting direction L1 (shown in FIG. 1).

Similarly, in the third embodiment, the second light-adjusting element 320 may include a second metalens (not shown), and the second emitted light of the second light-emitting element 220 may be deflected (e.g., deflected to the left) by the second metalens and have the second light-emitting direction L2 (shown in FIG. 1). The third light-adjusting element 330 may include a third metalens (not shown), and the third emitted light of the third light-emitting element 230 may be deflected (e.g., deflected to the right) by the third metalens and have the third light-emitting direction L3 (shown in FIG. 1). The size, distribution and/or pitch of the microstructures included in the second metalens and the third metalens may be different from that of the microstructures ST of the first metalens 314. According to the above structural design, the plurality of light-adjusting elements of the light adjusting layer 300 have different types of metalenses, which may enable the emitted light of the light-emitting elements 200 in different regions has different emitting angles, so that the uniformity of the projected image and light brightness are improved.

In some embodiments, as shown in FIG. 8, the display device DE may further optionally include another substrate 102 and an adhesive layer AL, and the adhesive layer AL may be disposed on the surface of the substrate 102. The adhesive layer AL may cover the first metalens 314 of the first light-adjusting element 310, the second metalens of the second light-adjusting element 320 and the third metalens of the third light-adjusting element 330. That is to say, the adhesive layer AL may be disposed between the light adjusting layer 300 and the substrate 102. In other embodiments, the display device DE may further include another adhesive layer (e.g., the adhesive layer AL1 shown in FIG. 7) disposed between the light-emitting layer EL and the light adjusting layer 300 and covering the second electrode E2, but not limited herein.

In addition, FIG. 8 shows the light-emitting element 200 is a vertical-type light-emitting element of another embodiment. The detailed structure of the light-emitting element 200 according to another embodiment of the present disclosure will be further described in the following. Specifically, as shown in FIG. 8, one light-emitting element 200 may include a light-emitting unit LU, a first electrode E1, a second electrode E2, a reflective unit RU, a filling material FI, a connection pad CP1 and a connection pad CP2. The first electrode E1 and the second electrode E2 may be disposed at two sides of the light-emitting unit LU and opposite to each other in the second direction D2. In some embodiments, the reflective unit RU and the first electrode E1 may include the same material. The connection pad CP1 and the connection pad CP2 may be disposed on the substrate 100, the connection pad CP1 is disposed in the opening OP of the organic layer OL, and the connection pad CP2 is not disposed in the opening OP of the organic layer OL. The reflective unit RU may be disposed around the light-emitting unit LU and does not extend to the bottom of the filling material FI. The light-emitting unit LU may be electrically connected to the connection pad CP1 through the first electrode E1. The second electrode E2 is connected to the reflective unit RU, and the second electrode E2 may extend to the upper surface of the organic layer OL and be connected to the connection pad CP2 through a connection hole VI in the organic layer OL, so that the light-emitting unit LU may be electrically connected to the connection pad CP2 through the second electrode E2. The filling material FI may be filled between the reflective unit RU and the second electrode E2, and the filling material FI may surround the light-emitting unit LU. In some embodiments, the opening OP of the organic layer OL may further be filled with an underfill material UFI, but not limited herein.

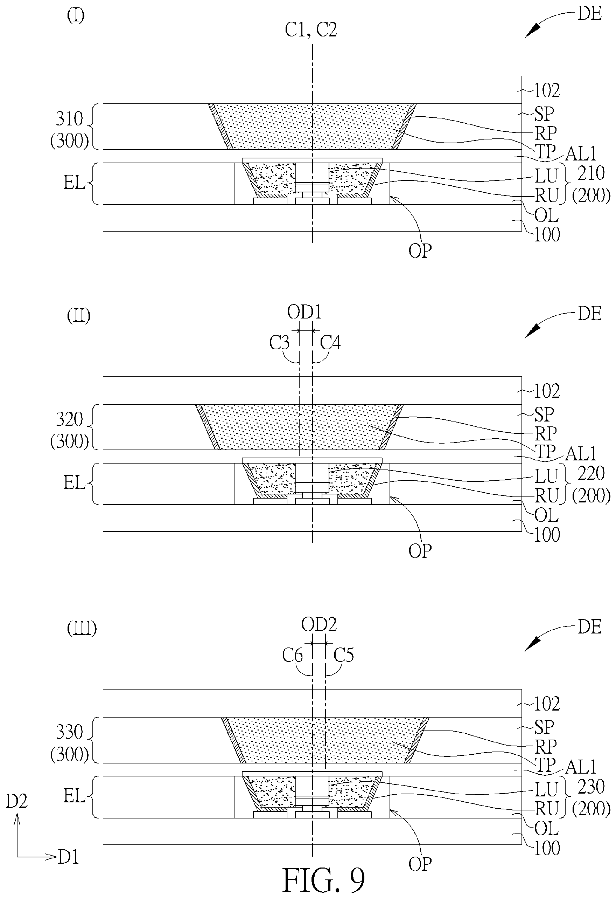

Please refer to FIG. 9, in conjunction with FIG. 1. FIG. 9 is a partial cross-sectional schematic diagram of a display device according to a fourth embodiment of the present disclosure, wherein the cross-sectional structures at the upper portion, the middle portion and the lower portion of FIG. 9 may correspond to the first region I, the second region II and the third region III shown in FIG. 1, respectively. According to the embodiment shown in FIG. 9, corresponding to the first region I of the substrate 100, the first light-adjusting element 310 may include a light-transmitting portion TP and a reflective portion RP, the reflective portion RP is disposed around the light-transmitting portion TP, and in a cross-sectional view of the display device DE, a central axis C1 of the first light-adjusting element 310 is coincided with a central axis C2 of the first light-emitting element 210. The central axis C1 of the first light-adjusting element 310 may be the central axis of the light-transmitting portion TP thereof, and the central axis C2 of the first light-emitting element 210 may be the central axis of the light-emitting unit LU thereof. The first emitted light of the first light-emitting element 210 may pass through the light-transmitting portion TP and have the first light-emitting direction L1 (shown in FIG. 1).

Corresponding to the second region II of the substrate 100, the second light-adjusting element 320 may include a light-transmitting portion TP and a reflective portion RP, the reflective portion RP is disposed around the light-transmitting portion TP, and in a cross-sectional view of the display device DE, a central axis C3 of the second light-adjusting element 320 is offset from a central axis C4 of the second light-emitting element 220. The central axis C3 of the second light-adjusting element 320 may be the central axis of the light-transmitting portion TP thereof, and the central axis C4 of the second light-emitting element 220 may be the central axis of the light-emitting unit LU thereof. As shown in FIG. 9, the central axis C3 of the second light-adjusting element 320 may be offset from the central axis C4 of the second light-emitting element 220 to the left, i.e., a distance OD1 exists between the central axis C3 and the central axis C4 in the first direction D1, so that the second emitted light of the second light-emitting element 220 may be deflected (e.g., deflected to the left) by the second light-adjusting element 320 and have the second light-emitting direction L2 (shown in FIG. 1).

Corresponding to the third region III of the substrate 100, the third light-adjusting element 330 may include a light-transmitting portion TP and a reflective portion RP, the reflective portion RP is disposed around the light-transmitting portion TP, and in a cross-sectional view of the display device DE, a central axis C5 of the third light-adjusting element 330 is offset from a central axis C6 of the third light-emitting element 230. The central axis C5 of the third light-adjusting element 330 may be the central axis of the light-transmitting portion TP thereof, and the central axis C6 of the third light-emitting element 230 may be the central axis of the light-emitting unit LU thereof. As shown in FIG. 9, the central axis C5 of the third light-adjusting element 330 may be offset from the central axis C6 of the third light-emitting element 230 to the right, i.e., a distance OD2 exists between the central axis C5 and the central axis C6 in the first direction D1, so that the third emitted light of the third light-emitting element 230 may be deflected (e.g., deflected to the right) by the third light-adjusting element 330 and have the third light-emitting direction L3 (shown in FIG. 1). According to the above structural design of the light-adjusting elements of the light adjusting layer 300, the emitted light of the light-emitting elements 200 in different regions may have different emitting angles, so that the uniformity of the light brightness may be improved and the distortion of the projected image may be reduced.

In some embodiments, as shown in FIG. 9, the display device DE may further optionally include another substrate 102 and an adhesive layer AL1, the light adjusting layer 300 may be disposed on the surface of the substrate 102 located at one side of the substrate 102, and the light adjusting layer 300 may be attached to the light-emitting layer EL through the adhesive layer AL1, i.e., the light adjusting layer 300 may be located between the adhesive layer AL1 and the substrate 102 in the second direction D2.

From the above description, according to the display devices of the embodiments of the present disclosure, through disposing the light adjusting layer including a plurality of light-adjusting elements on the light-emitting elements, the emitted light of the light-emitting elements in different regions has different emitting angles, so that the uniformity of the light brightness may be improved and the distortion of the projected image may be reduced, thereby improving the image quality. In addition, the light-adjusting elements in different regions may have different optical structure designs.

For those skilled in the art, the technical features disclosed in the aforementioned embodiments can be replaced or recombined with one another to constitute another embodiment without departing from the spirit of the present disclosure.

## Claims

1. A display device (DE) used for projecting light (L) to an object (OB) having a first curved surface (S1) and a second curved surface (S2), **characterized by** comprising:
a substrate (100) having a first region (I) overlapping the first curved surface (S1) and a second region (II) overlapping the second curved surface (S2), wherein an included angle (α2) between a normal direction (D2) of the substrate (100) and a normal direction (N2) of the second curved surface (S2) is greater than an included angle (α1) between the normal direction (D2) of the substrate (100) and a normal direction (N1) of the first curved surface (S1);
a plurality of light-emitting elements (200) disposed on the substrate (100) and comprising a first light-emitting element (210) and a second light-emitting element (220), wherein the first light-emitting element (210) is disposed in the first region (I), and the second light-emitting element (220) is disposed in the second region (II); and
a light adjusting layer (300) disposed on the plurality of light-emitting elements (200) and comprising a first light-adjusting element (310) and a second light-adjusting element (320), wherein the first light-adjusting element (310) is used for enabling the first light-emitting element (210) to emit a first emitted light with a first light-emitting direction (L1), and the second light-adjusting element (320) is used for enabling the second light-emitting element (220) to emit a second emitted light with a second light-emitting direction (L2),
wherein an included angle (β2) between the second light-emitting direction (L2) and the normal direction (D2) of the substrate (100) is greater than an included angle (β1) between the first light-emitting direction (L1) and the normal direction (D2) of the substrate (100).

2. The display device (DE) according to claim 1, **characterized in that** the first light-adjusting element (310) comprises a first prism portion (312), the second light-adjusting element (320) comprises a second prism portion (322), and in a cross-sectional view of the display device (DE), the first prism portion (312) comprises a plurality of symmetric structures (ST1), and the second prism portion (322) comprises a plurality of asymmetric structures (ST2).

3. The display device (DE) according to claim 2, **characterized by** further comprising another substrate (102) and an adhesive layer (AL) disposed on a surface of the another substrate (102), wherein the adhesive layer (AL) covers the first prism portion (312) and the second prism portion (322).

4. The display device (DE) according to claim 2 or 3, **characterized in that** the first light-adjusting element (310) comprises a light-transmitting portion (TP) and a reflective portion (RP), the reflective portion (RP) is disposed around the light-transmitting portion (TP), and the first prism portion (312) is disposed on the light-transmitting portion (TP).

5. The display device (DE) according to claim 4, **characterized in that** in the cross-sectional view, a top surface width (W1) of the light-transmitting portion (TP) is greater than a bottom surface width (W2) of the light-transmitting portion (TP).

6. The display device (DE) according to claim 2 or 3, **characterized in that** the first light-adjusting element (310) comprises a light-transmitting portion (TP) and a reflective portion (RP), the reflective portion (RP) is disposed around the light-transmitting portion (TP), and the first prism portion (312) is embedded in the light-transmitting portion (TP).

7. The display device (DE) according to claim 6, **characterized in that** in the cross-sectional view, a top surface width (W1) of the light-transmitting portion (TP) is greater than a bottom surface width (W2) of the light-transmitting portion (TP).

8. The display device (DE) according to claim 1, **characterized in that** the first light-adjusting element (310) comprises a first metalens (314), and the second light-adjusting element (320) comprises a second metalens.

9. The display device (DE) according to claim 8, **characterized in that** the first light-adjusting element (310) comprises a light-transmitting portion (TP) and a reflective portion (RP), the reflective portion (RP) is disposed around the light-transmitting portion (TP), and the first metalens (314) includes a plurality of microstructures (ST) and is disposed on the light-transmitting portion (TP).

10. The display device (DE) according to claim 1, **characterized in that** the first light-adjusting element (310) comprises a light-transmitting portion (TP) and a reflective portion (RP), the reflective portion (RP) is disposed around the light-transmitting portion (TP), and in a cross-sectional view of the display device (DE), a central axis (C1) of the first light-adjusting element (310) is coincided with a central axis (C2) of the first light-emitting element (210).

11. The display device (DE) according to claim 1, **characterized in that** the second light-adjusting element (320) comprises a light-transmitting portion (TP) and a reflective portion (RP), the reflective portion (RP) is disposed around the light-transmitting portion (TP), and in a cross-sectional view of the display device (DE), a central axis (C3) of the second light-adjusting element (320) is offset from a central axis (C4) of the second light-emitting element (220).

12. The display device (DE) according to any one of claims 1-11, **characterized in that** the first light-emitting element (210) comprises a light-emitting unit (LU) and a reflective unit (RU), and the reflective unit (RU) is disposed around the light-emitting unit (LU).

13. The display device (DE) according to claim 12, **characterized by** further comprising an organic layer (OL) disposed on the substrate (100), wherein the organic layer (OL) comprises an opening (OP), and the light-emitting unit (LU) and the reflective unit (RU) are disposed in the opening (OP).

14. The display device (DE) according to claim 12 or 13, **characterized in that** in a cross-sectional view of the display device (DE), the reflective unit (RU) has a bottom part (RUa) and a side wall (RUb), and an included angle (θ) between the side wall (RUb) and the bottom part (RUa) ranges from 100 degrees to 170 degrees.

15. The display device according to claim 14, wherein the first light-emitting element (210) further comprises a first electrode (E1) and a second electrode (E2) respectively disposed at two opposite sides of the light-emitting unit (LU), and the second electrode (E2) is connected to the side wall (RUb) of the reflective unit (RU).
